# EUROPEAN PATENT SPECIFICATION

(11) **EP 2 294 488 B1**
(45) Date of publication and mention of the grant of the patent: **06.04.2022**
(21) Application number: 09767061.6
(22) Date of filing: 17.06.2009
(51) Int. Cl.: G05B 19/418, G01D 21/00, G08C 17/02

(54) **RF ADAPTER FOR FIELD DEVICE WITH LOW VOLTAGE INTRINSIC SAFETY CLAMPING**
HF-ADAPTER FÜR EINE EINSATZORTEINRICHTUNG MIT INTRINSISCHER SICHERHEITSKLEMMUNG NIEDRIGER SPANNUNG
ADAPTATEUR RF POUR DISPOSITIF DE TERRAIN À SERRAGE DE SÉCURITÉ INTRINSÈQUE À FAIBLE TENSION

(30) Priority: 17.06.2008 US 73094
(43) Date of publication of application: 16.03.2011
(73) Proprietor: Rosemount Inc., Chanhassen, MN 55317 (US)
(72) Inventor: KIELB, John, A., Eden Prairie MN 55346 (US); WESTFIELD, Brian, L., Victoria MN 55386 (US); ORTH, Kelly, M., Apple Valley MN 55124 (US)
(74) Representative: Isarpatent
(86) International application number: PCT/US2009/003616
(87) International publication number: WO 2009/154748

(56) References cited:
- EP-A1- 1 202 145
- GB-A- 2 403 043
- US-A1- 2005 289 276

## Description

### BACKGROUND OF THE INVENTION

The present invention relates to industrial process control or monitoring systems. More specifically, the present invention relates to field devices in such systems which are capable of Radio Frequency (RF) communication.

U.S. Patent Publication No. 2005/289276 describes a field device for use in an industrial process control or monitoring system using power supply circuitry that powers radio frequency communication circuitry using power received from a two-wire process control loop.

EP1202145 A1 discloses field devices comprising a transmitter and/or receiver for wireless data communication, wherein the energy available for wireless data communication in data transmitting or data receiving field devices is evaluated prior to activation of the transmitter and/or receiver of the field device.

GB2403043 A discloses a method of configuring a wireless enabled field device comprises receiving the field device identification information, which could include a device tag, comparing the identification information to a configuration database, retrieving the configuration information associated with the field device and sending the configuration information to the field device via at least one wireless communication link to configure the field device. The identification information could also comprise an updated list of information associated with a plurality of wireless enabled field devices and a message from a controller. Also disclosed is a method of establishing a communication network for use in a process control system.

In industrial settings, control systems are used to monitor and control inventories of industrial and chemical processes, and the like. Typically, the control system performs these functions using field devices distributed at key locations in the industrial process and coupled to the control circuitry in the control room by a process control loop. The term "field device" refers to any device that performs a function in a distributed control or process monitoring system, including all devices currently known, or yet to be known, used in the measurement, control and monitoring of industrial processes.

Some field devices include a transducer. A transducer is understood to mean either a device that generates an output signal based on a physical input or that generates a physical output based on an input signal. Typically, a transducer transforms an input into an output having a different form. Types of transducers include various analytical equipment, pressure sensors, thermistors, thermocouples, strain gauges, flow transmitters, positioners, actuators, solenoids, indicator lights, and others.

Typically, each field device also includes communication circuitry that is used for communicating with a process control room, or other circuitry, over a process control loop. In some installations, the process control loop is also used to deliver a regulated current and/or voltage to the field device for powering the field device. The process control loop also carries data, either in an analog or digital format.

Traditionally, analog field devices have been connected to the control room by two-wire process control current loops, with each device connected to the control room by a single two-wire control loop. Typically, a voltage differential is maintained between the two wires within a range of voltages from 12-45 volts for analog mode and 9-50 volts for digital mode. Some analog field devices transmit a signal to the control room by modulating the current running through the current loop to a current proportional to the sensed process variable. Other analog field devices can perform an action under the control of the control room by controlling the magnitude of the current through the loop. In addition to, or in the alternative, the process control loop can carry digital signals used for communication with field devices.

In some installations, wireless technologies have begun to be used to communicate with field devices. For example, completely wireless installations are used in which the field device uses a battery, solar cell, or other technique to obtain power without any sort of wired connection. However, the majority of field devices are hardwired to a process control room and do not use wireless communication techniques. Further, in many field installations, "intrinsic safety" standards must be implemented which limit the amount of stored energy which can be discharged into the environment.

### SUMMARY OF THE INVENTION

An adapter for coupling to a process control transmitter of the type used to monitor a process variable in an industrial process as defined in appended claim 1.

### BRIEF DESCRIPTION OF THE DRAWINGS

Figure 1 is a simplified block diagram of a process control monitoring system including a field device configured for wireless communication.
Figure 2 is a block diagram of a process controller monitoring system in which multiple field devices transmit information to a remote meter.
Figure 3 is an exploded cut away view of a field device including wireless communication circuitry for communicating with a remote device such as a hand held unit.
Figure 4 is a diagram of a process controller monitoring system which includes a field device for wireless communication which scavenges power from the process control loop.
Figure 5 is a more detailed schematic diagram of circuitry shown in Figure 4.
Figure 6 is a graph of voltage versus time as measured across a capacitor shown in Figure 5.
Figure 7 is an electrical block diagram of circuitry for providing wireless communications in a process controller monitoring system.
Figures 8A and 8B are block diagrams showing a wireless communication adapter coupled to a process variable transmitter through a two wire process control loop.
Figure 9 is a simplified block diagram showing circuitry of a wireless communication adapter.
Figure 10 is a simplified cross-sectional view showing a wireless adapter coupled to a transmitter.
Figure 11 is a simplified diagram showing a process control loop including an intrinsic safety barrier.
Figure 12 is a simplified schematic diagram showing a wireless adapter including intrinsic safety circuitry.
Figure 13 is a more detailed schematic diagram of the wireless adapter of Figure 12.
Figure 14 is a simplified schematic diagram showing intrinsic safety circuitry showing active circuitry.
Figure 15 is a simplified schematic diagram showing the wireless adapter using active intrinsic safety circuitry.
Figure 16 is a more detailed schematic diagram of the wireless adapter of Figure 15.

### DETAILED DESCRIPTION OF ILLUSTRATIVE EMBODIMENTS

The present invention provides an adapter for coupling to a process control transmitter of the type used to monitor a process variable in an industrial process, as defined in appended claim 1.

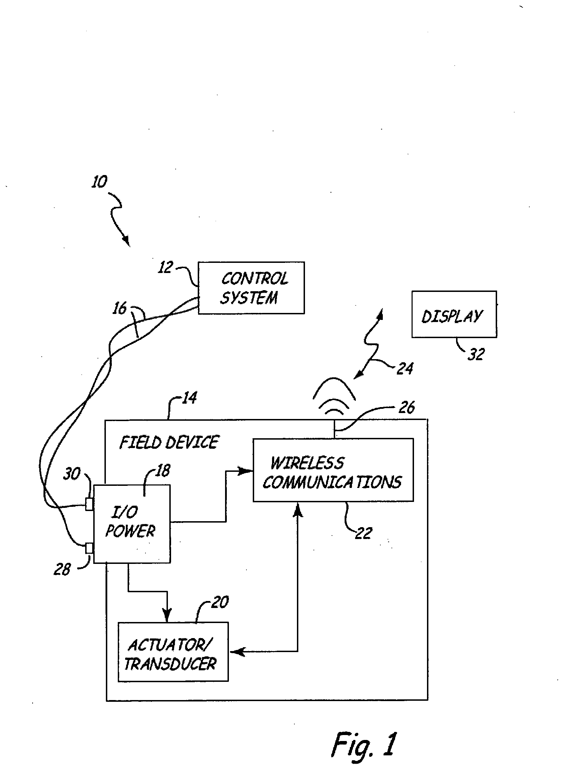

Figure 1 is a simplified block diagram of a process control or monitoring system 10 in which a control room or control system 12 couples to a field device 14 over a two-wire process control loop 16. The field device 14 includes I/O power circuitry 18, actuator/transducer 20 and wireless communication circuitry 22. The wireless communication circuitry 22 is configured to send and/or receive an RF signal 24 using an antenna 26.

Currently, industrial instrumentation often includes a local display or "meter" which can be used for local monitoring of process information. The meter can be quite useful in many installations, however, such a local display configuration does have several limitations. A local display requires direct visual access to the field device. Further, typically an operator can only view a single meter at a time. The instruments which contain the meter are often not at a convenient location or viewing angle. One technique which has been used to address such a configuration is the use of a meter which is wired to a process transmitter. This allows the meter to be mounted at a more convenient location. Another technique is shown and described in U.S. patent application Serial No. 10/128,769, filed April 22, 2002, entitled PROCESS TRANSMITTER WITH WIRELESS COMMUNICATION LINK.

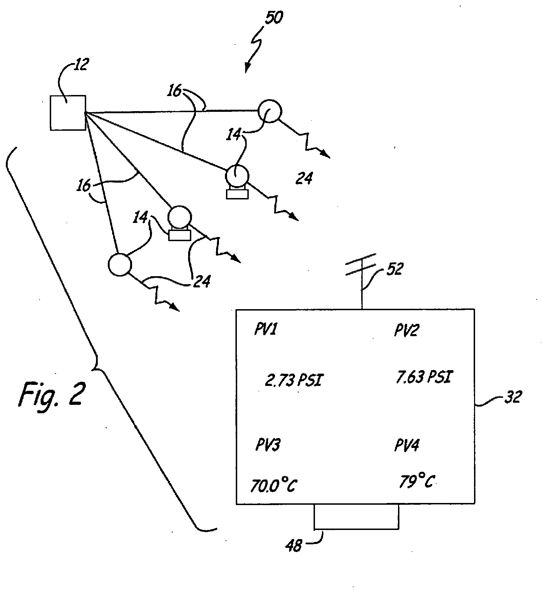

With the present invention, an RF communication module is configured as an adapter to retrofit a field device which can be used in addition to the connection to a process control loop such as loop 16. The wireless communication module 22 can be configured to be compact and lower power such that it can be easily included in existing field device configurations. The module can be used for wireless transmission of information for use in monitoring control and/or display of data. Such a radio transmitter can make the field device information available in a local area. For example, a single local display such as display 32 can be provided and used to display information from the field device 14. The display 32 can be configured to display information from several devices, either simultaneously, sequentially, or through commands provided to the display, for example using a manual input such as buttons available to an operator. The display 32 can be placed at a fixed location or can be a portable device such that it can be carried throughout the process control system to monitor and observe operation of various field devices. Depending on the strength of the RF signal 24 and the sensitivity of the transmit and receive circuitry, the area covered by the RF transmission can be controlled as desired. For example, Figure 2 is a simplified diagram of a process control system 50 in which a number of field devices 14 are coupled to the control room 12 through individual process control loops 16. Each field device 14 transmits an RF signal 24 for receipt by display 32. In this example, display 32 is capable of displaying four process variables (PV1, PV2, PV3 and PV4) which are received from the field devices 14 using antenna 52. As mentioned above, the display 32 can be a fixed display or can be a portable display, such as a hand held unit. In this particular configuration, the display 32 is illustrated as showing two process variables which relate to process pressure and two process variables which relate to process temperature. This allows the field devices 14 to provide information over the RF connection within a desired range, for example, within a local area. For example, if the display 32 is within 40 meters of a field device 14, it will be capable of receiving and displaying information from that field device. An optional user input 48 can be used to, for example, select the format of the display, the process variable displayed, or used to interrogate a field device 14.

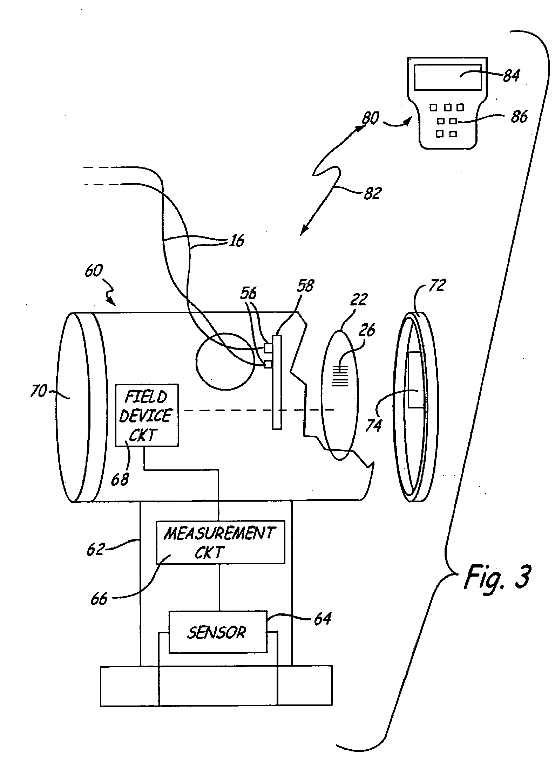

Figure 3 is a simplified cutaway partially exploded view of a pressure transmitter 60 which is one example of a field device. Pressure transmitter 60 couples to two-wire process control loop 16 and includes a transmitter housing 62. Process control loop 16 couples to terminals 56 carried on terminal board 58. A pressure sensor 64 provides one example of a transducer and is configured to couple to a process fitting to measure a differential pressure occurring in a process fluid. The output from the sensor 64 is provided to measurement circuitry 66 which couples to field device circuit 68. The field device circuit 68 implements aspects of the I/O power supply 18 shown in Figure 1. The wireless communication circuitry 22 couples to field device circuit 68 and may, in some embodiments, couple to process control loop 16.

The housing 62 includes end caps 70 and 72 which can be screwed into the housing 62. End cap 72 includes an RF transparent window 74 configured to align generally with an antenna 26 carried on wireless communication circuit 22. When attached, the end caps provide a intrinsically safe enclosure for circuitry within transmitter 60. The materials typically used in end caps, for example metal, are not transparent to RF signals. However, RF transparent window 74 allows RF signals to be sent from or received by antenna 26. One example RF transparent material for use with window 74 is glass or the like. However, any appropriate material can be used. The window and housing configuration can help to meet intrinsic safety requirements and provide flame proof (explosion proof) capability. Further, the cavity within housing 62 can be configured to provide a desired radiation pattern of RF signals generated by antenna 26. For example, it may be desirable to have the RF transmission be directional in some implementations, or omnidirectional in others. In other implementations, the cover 62 can be lengthened to provide an additional interior cavity for placement of wireless communication circuit 22.

The wireless communication circuitry 22 can be selected as desired. One example circuit is the "I-Bean" transmitter device available from Millennial Net. However, other circuitry can be used. Analog or digital signals carried on process control loop 16 can be read and transmitted using the wireless communication circuit 22 without disrupting operation of the process control loop 16 or field device circuitry 68. The circuitry used for wireless transmission should be sufficiently small and low powered to fit within the physical and power constraints of process field devices. Some prior art transmitters are configured to receive an optional display arranged generally in the position shown for wireless communication circuit 22 in Figure 3. In such a configuration, the wireless communication circuit 22 can be used in place of the local display. In such a configuration, the communication wireless circuitry 22 simply transmits an RF signal which couples directly to the process control loop 16 and transmits an RF signal which corresponds to any analog and/or digital signals carried on the loop 16.

In general, the process control loop discussed herein can comprise any type of process control loop for use in industrial process control and monitoring systems. Such loops include 4-20mA current loops in which a analog current level is varied between 4 and 20mA to transmit information. The same control loop can be used to provide power to the field device. Another type of process control loop is in accordance with the HART@ communication protocol in which digital transmissions are superimposed on the 4-20mA signal for transmission of additional information. Another example two-wire process control loop uses a protocol set forth by the Instrument Society of America (ISA) which is called the Field Bus SP50 protocol. However, end signaling protocol can be used. Some process control loops are configured to connect to multiple field devices such that the field devices can communicate with one another or monitor transmissions from another field device. In general, any type of information transmitted on such process control loops, or available or generated internally or received by a field device, or otherwise used to control a field device or other type of information, can be transmitted using the wireless communication techniques of the present invention. In another example, a hand held unit or device used to configure field devices can be carried into the field by an operator. The operator uses the hand held device to send or receive information to a field device when the hand held device is within proximity of the field device. This allows the operator to gather information or program a field device without having to physically couple to the device or the physical process control loop.

In some embodiments, it is also desirable for communications from a field device, or to a field device, to carry addressing information. The addressing information can be indicative of the source of the transmission or the intended recipient of the transmission. The wireless communication circuitry can transmit continuously or on a periodic or intermittent basis, as desired. In another example, the wireless communication circuitry only transmits when activated or "polled". The activation can be from a source internal to the field device, received through the process control loop, received from a wireless source, or received or generated by another source. In environments in which multiple field devices may transmit simultaneously, the transmission protocol should be selected to avoid or address any type of collisions which might interfere with the transmissions. For example, different frequencies or frequency skipping techniques can be used, random or semi-random transmission windows can be used, repeated transmissions or token based techniques can be implemented or other collision avoidance techniques as desired. If the transmission includes error detection or correction information, this information can be used to detect an error in the transmission and/or correct any errors in the transmissions. If an error is not correctable, the receiving unit can request a re-transmission of the corrupt data or, can indicate an error, or can wait for a subsequent transmission of the data, or take other steps as desired.

Figure 3 also shows an example hand held device 80 for communication with circuitry 22 over RF connection 82. Hand held device 80 includes a display 84 and user input 86. Other types of inputs and outputs can be included in hand held device 80. Preferably, the hand held device 80 is battery operated and can be carried into the field by an operator for communication with field device 60. Information from the field device 60, or from other sources, is displayed on display 84 and the hand held device is controlled using input 86. Commands or other information can be transmitted by the hand held device 80 to field device 60.

In one configuration, the wireless communication circuitry requires power which is within the power constraints available in the field device. For example, one display currently used within field devices uses 3.6 volts at 0.5 mA. If a transmitter which is capable of operating an LCD meter is employed, the wireless communication circuitry can replace the LCD meter and use the same power source that is used to drive the LCD meter. In another example, the wireless communication circuitry is powered directly from the process control loop, for example using the voltage developed across a diode drop connected in series with the process control loop. In embodiments in which no battery is used with the communication circuitry, the circuitry can more easily meet intrinsic safety or other safety approval requirements and provide an indefinite field life without battery replacement or maintenance. In configurations in which the wireless configuration is only for sending information, power requirements can be reduced. In another example, if a greater transmission range is desired, a stationary device such as display 32 as illustrated in Figure 1 can include an RF repeater for re-transmission of data received from, or sent to, a field device. The RF repeater can be loop powered, or can derive its power from other sources. Further, once the RF data is received, it can be reformatted for transmission over other medium, for example an Ethernet connection, into existing data transmission structures used within process control systems, over an extended range RF communication link such as a cell phone, or relaying using another technique.

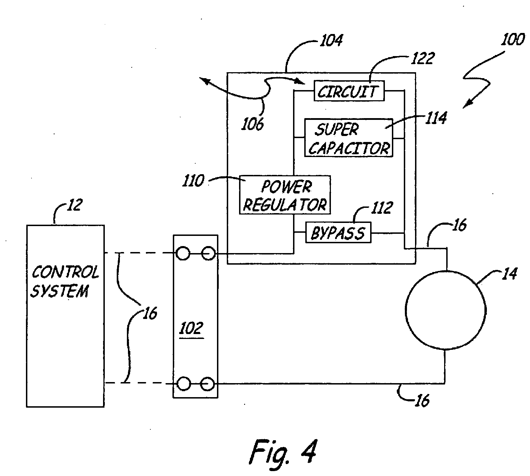

Figure 4 is a simplified diagram of a process controller or monitoring system 100 which illustrates another aspect of the present invention. In system 100, a field device 14 connects to a control system 12 through process control loop 16 through junction box 102. In the embodiment of Figure 4, a field device 104 couples to the process control loop 16 and includes wireless communication circuitry 122. The wireless communication circuitry 122 is configured to send an RF signal 106 and to be completely powered by power received from the process control loop 16.

Process device 104 includes a power regulator 110, a shunt or bypass 112, and a super capacitor 114. During operation, the super capacitor 114 is slowly charged (trickle charged) using a power regulator 110 by using excess voltage tapped from the process control loop 16. The bypass 112 allows loop 16 to operate normally and is connected in series with loop 16. Communication circuit 122 includes circuitry for receiving analog and/or digital information carried on process control loop 16. The circuit 122 can responsively transmit an RF signal 106 based upon the received information. If operated as a receiver, circuitry 122 is capable of modulating data onto the electrical current carried in the loop 16. This can be either analog or digital information. This configuration allows data to be relayed over a wireless communication network. The network can be configured in accordance with any type of topology, including point to point, spoke and hub and mesh topologies. Process device 104 can be positioned at any location along the loop including configured as an individual device such as that illustrated in Figure 4. In some installations, the field device 104 should be field hardened and configured for intrinsically safe operation. The device 104 can also be positioned within another field device 14, as part of a junction box 102, or even located within the control room which houses control system 12. The field device 104 can connect to more than one RF circuit 122 and/or more than one process control loop 16, either simultaneously or through the use of multiplexers or other techniques.

The use of a super capacitor allows the device to operate without internal batteries or other techniques. The use of a capacitor allows quick charging and the storage of sufficiently large energy potentials. When used in a hazardous environment, large energy storage may not be acceptable in order to meet intrinsic safety standards. However, the process device 104 can be moved away from the hazardous environment, such as at the junction box 102, where intrinsic safety is not required.

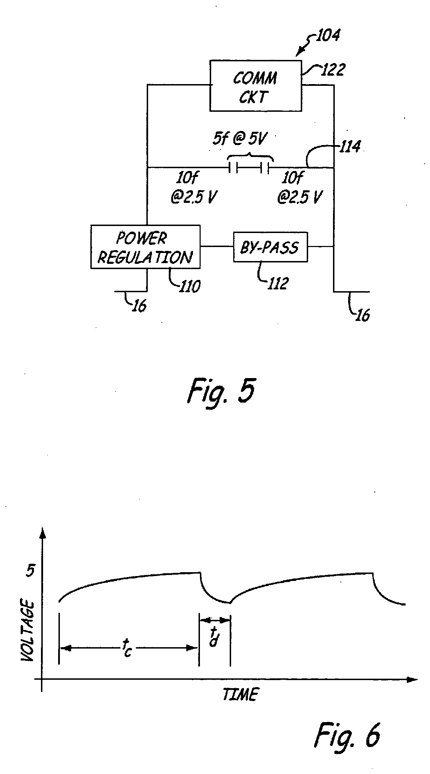

Figure 5 is a simplified schematic diagram of field device 104 showing super capacitor 114 in greater detail. In this example, super capacitor 114 comprises two 10 Farad capacitors configured to each carry a 2.5 volt potential. This yields an equivalent capacitance of 5 farads with a 5 volt potential drop. Assuming that the wireless communication circuit 122 is capable of operating at a voltage of between 4 and 5 volts, the available energy from each of the 5 Farad capacitors is ½^{∗}C(Vᵢ²-V_{F}²) which is ½^{∗}5^{∗}(5²-4²)=22.5J.

Figure 6 is a graph of voltage versus time measured across super capacitor 114. In this example, 600mW wireless transmitter which transmits a burst signal for a period of t_{d} of 1 second will require 0.6J/S^{∗}1s=0.6J of energy. Thus, there is ample energy available for operation of such a communication circuit 122.

A typical power supply used to provide power to a process control loop provides 24 volts DC. However, in a 4-20mA system, a transmitter may only require 12 volts to operate. Wiring losses in the process control loop may cause 2 to 4 volts of voltage drop. Assuming only 5 volts is available for charging the super capacitor 114, and that the process control loop is operating at a low current level (i.e., 4mA), there is still 20mW available to charge the super capacitor 114. Because only 0.6J was consumed during the transmit cycle, the available 20mW will charge the super capacitor to full capacity in a time t_{c}=0.6J/0.02W=30s. Therefore, such a configuration will be capable of transmitting a signal having a 1 second duration every 30 seconds. Assuming that the bandwidth of the communications signal is 200Kb/s and a packet size of 200b, the burst time is reduced to one millisecond and the resulting transmit time is 0.03 seconds. In such a configuration, diagnostic data can easily be transmitted because it is not of a time critical nature. However, if sufficiently fast charge times are available, control and process variable signals can also be transmitted wirelessly.

Although a super capacitor is described, any energy storage device can be employed including a battery, or other. The energy that is used to charge the storage device can be electrical or magnetic and can be derived or collected from any source.

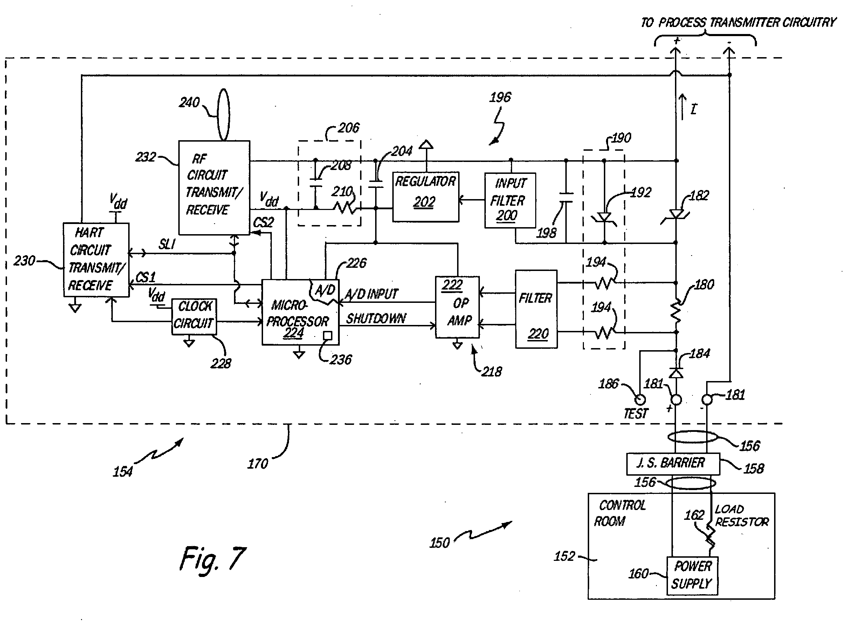

Figure 7 is a simplified diagram of process controller monitoring system 150 which includes a control room 152 coupled to a field device 154 through two-wire process control loop 156. Process control loop 156 extends across an intrinsic safety barrier 158. The control room 152 is modeled as including a power supply 160 and a load resistance 162.

The field device 154 can be of any configuration and is not limited to the specific schematic shown in Figure 7. RF communication circuitry 170 is shown coupled in series with loop 156. Circuitry 170 can be implemented in a terminal block of a field device. For example, circuitry 170 can be configured as an add on module such that the two-wire process control loop 156 can connect to existing transmitter circuitry.

In the configuration illustrated in Figure 7, the communication circuitry 170 enables wireless communication abilities to be added to a new or existing process control loop or field device. The circuitry is configured to be powered by the process control loop and can be installed anywhere in the loop ranging from the control room, anywhere along the loop itself, in the intrinsic safety (IS) barrier or junction box 158, as a stand alone field device, or included in another field device. The circuitry can be configured for any type of communication. However, in one simple configuration, the circuit 170 is configured to measure the current carried in process control loop 156 and transmit an output related to the measured current to a wireless receiver.

Turning now to one specific embodiment of circuitry 170 shown in Figure 7, a sense resistance 180 and a power supply diode 182 couple in series with process control loop 156. The sense resistance 180 can be, for example, 10 ohms and is used in sensing the current level I carried in the process control loop 156. A test diode 184 is also coupled in series with the loop 156 and provides a test point 186. This can be used to calibrate or characterize a field device coupled to circuitry 170. An intrinsic safety protection circuit 190 is provided which includes diode 192 connected as shown across diode 182 and isolation resistors 194 connected at opposed ends of sense resistance 180. Diode 182 is part of a power supply 196 which includes capacitor 198, input filter 200, regulator 202, capacitor 204 and secondary filter 206. Secondary filter 206 includes capacitor 208 and resistor 210. The power supply circuitry 196 generates a power supply voltage V_{DD} relative to a circuit ground for use by circuitry in measuring the loop current and wirelessly transmitting a resultant signal. Although a specific power supply implementation is shown, any appropriate power supply configuration or embodiment may be used as desired.

In this embodiment, input circuitry 218 includes sense resistance 180 and is configured to measure the current I flowing through loop 156. Input circuitry 218 also includes a filter 220 which provides a differential connection to an OP amp 222. The OP amp provides an amplified input signal to an analog to digital converter 226 which is illustrated as part of a microprocessor 224. A clock circuit 228 is provided and used to provide a clock signal to, for example, microprocessor 224. Optional HART^{®} transmit and receive circuit 230 connects to microprocessor 224, loop 156, clock circuit 228 and an RF transmit/receive circuit 232. The optional HART^{®} circuit 230 is configured to receive a digital chip select signal (CS1) from microprocessor 224. The RF circuit 232 is configured to receive a separate digital chip select signal (CS2) from microprocessor 224. Both the HART^{®} circuit 230 and the RF circuit 232 are configured to communicate with the microprocessor 224 on an SCI bus, depending on which chip select is active. Microprocessor 224 is also configured to provide a shut down signal to operational amplifier 222. Microprocessor 224 includes a memory 236 which is used for storing programming instructions, temporary and permanent variables and other information and may include both volatile and non-volatile memory. The memory can include, for example, an EEPROM and can contain addressing information which uniquely identifies circuitry 170. RF circuit 232 couples to an antenna 240 which can be configured as an internal antenna, external antenna, or combination, as desired. Circuitry 170 is configured to couple across the two-wire process control loop 156 such that the loop 156 can terminate at another field device such as a process transmitter or process controller.

The circuitry 170 illustrated in Figure 7 can be implemented on a single printed circuit board such that RF antenna 240 is formed integral with the board. This configuration allows the circuitry 170 to be easily implemented in existing field devices and does not require the use of an external antenna. This reduces installation complexity.

The optional HART^{®} transmit/receive circuit 230 can be used to monitor digital signals, such as a process variable, carried on the process control loop 156. Based upon the sensed digital signal, the HART^{®} circuitry 230 can control operation of the RF transmit/receive circuit 232 for transmission of information related to the sensed process variable, or other information. If the HART^{®} circuitry is implemented in accordance with the complete HART^{®} protocol and appropriate RF protocol stacks, the circuitry can implement gateway level functionality which will allow a HART^{®} master to communicate in a bi-directional manner through the RF HART^{®} gateway device with a HART^{®} capable field device on the process control loop 156. This allows wireless communication with a field device for monitoring, configuration, diagnostics, or exchange of other information or data.

Frequently, in process control or monitoring installations, an operator is required to physically access a field device or the process control loop in order to exchange information with the field device. This allows the operator to repair equipment and do preventive maintenance on the equipment. The wireless communication configuration set forth herein allows the operator to interrogate field devices which may be in locations which are difficult to access. Further, even in configurations in which the field devices are easily accessible, the wireless communication circuitry does not require an operator to remove covers on equipment such as transmitters or junction boxes in order to expose loop wiring for physical connection to the process control loop. This can be particularly beneficial in hazardous locations where explosive gases or vapors may be present. A digital or analog process variable can be sensed by the wireless communication circuitry and transmitted to a wireless meter or hand held device as discussed above.

During operation, circuit 170 is placed in series with the process control loop 156 where it utilizes the 4-20mA current flowing through the loop to power itself. For field devices that employ a common electrical ground, circuitry 170 can be inserted on the high voltage side of the loop connection. This configuration allows access to other bus circuitry within the field device such as a CAN interface. The configuration includes a test connection 186 for use in measuring loop current during testing. The sense resistance 180 is preferably configured to provide an equivalent capacitance of zero as measured at terminals 181 which connect to loop 156 in accordance with intrinsic safety standards. Circuitry 170 is configured for nominal operation at between 3 and 4 volts and the zener diode 182 along with sense resistance 180 sets this operating voltage. The excess voltage available on typical 4-20mA current loop is sufficient to operate circuitry 170. Further, power management techniques can be employed to limit the current drawn from the loop to about 3mA. This allows any field device connected to the process control loop to send an alarm level signal of 3.6mA without collapsing the circuit by drawing more than the available current level.

Zener diode 182 acts as a shunt element which is placed in series with the loop 156 to develop a preregulated voltage on the input filter stage. Any portion of the loop current which is not used by circuitry 170 is shunted through zener diode 182. The input filter 200 can comprise capacitive, inductive and resistive elements and is used to isolate the loop from any noise or load fluctuation generated by circuitry 170. This also suppresses noise in the HART^{®} extended frequency band in order to conform with HART^{®} standards.

The voltage regulator 202 can be any appropriate voltage regulator such as, but not limited to linear or switch mode regulators and is used to supply the voltage V_{DD} to the circuitry. Filter 206 is used to store energy and further decouples circuit loads from the regulator 202. The output voltage of the secondary filter 206 is allowed to sag by several hundred millivolts during circuit load changes. This allows peak current draws by the circuitry 172 to be averaged from the 4-20mA current loop.

In this embodiment, the microprocessor 224 including A/D converter, along with the RF circuitry 232 and input circuitry 218 can be placed into a sleep mode or low power mode during periods of idle operation in order to reduce power drain. For example, at a selected interval such as every 10 seconds, an internal timer in the microprocessor can enable the measurement of the loop current by the A/D converter. The measurement circuitry is allowed to settle before the A/D conversion occurs. After the A/D conversion is completed, both the loop measurement circuitry and the A/D converter are turned off to conserve power. The microprocessor passes the measured value to the RF circuitry 232 for transmission. Upon completion of the transmission, the microprocessor and RF circuitry return to the low power mode until the next cycle. The microprocessor may even put itself to sleep temporarily to save power. Using these power management techniques, the microprocessor is able to manage overall current requirements of the circuit by staggering the load demands on the regulator stage.

Loop current measurement is achieved using the 10 ohm sense resistor 180 coupled in series with the 4-20mA current loop 156 to measure the analog current level. The voltage developed across the sense resistor 180 is filtered to remove fluctuations due to HART@ digital communications as well as any loop noise. An operational amplifier stage 222 provides further signal conditioning and the signal is passed to the A/D converter 226 of microprocessor 224.

The RF circuitry 232 can be any appropriate circuitry or configuration as desired. In one simple form, the RF circuitry 232 simply transmits a measured variable to a wireless receiver. The antenna 240 can be used to broadcast the RF signal and can be formed integral with the circuitry 170, for example in the form of traces routed around an outside edge of a circuit board. The RF circuitry 232 can, in some embodiments, include a wireless receiver such that the circuitry 232 can be configured as a transceiver. The same antenna 240 can be used for both transmission and reception if desired. A typical low powered transceiver may have a communication range of about 200 feet, however other ranges can be achieved using different power requirements, circuit sensitivity, antenna configuration, and the like. If the circuitry 170 is mounted in a metal enclosure, such as a field housing compartment of a transmitter, an RF transparent portion of the housing should be used to allow transmission and reception of signals from antenna 240. For example, as discussed above, a glass window can be used. Other example materials include any material which is sufficiently transmissive to RF signals including plastic, or other materials.

The addition of the optional HART^{®} circuitry 230 allows the circuitry 170 to selectively listen to a HART^{®} message on the 4-20mA signal carried on the current loop 156. Information such as measured process variables, diagnostic information, or other information can be transmitted to a wireless receiver. Further, if the HART^{®} circuitry 230 is configured to modulate a digital signal onto the process control loop, it can be used to remotely command or interrogate a field device coupled to the loop 156. For example, the HART^{®} circuitry 230 can be configured to act as a secondary master on the 4-20mA current loop. This, in conjunction with RF circuitry 232 configured as a full transceiver, enables bi- directional communication and configuration of field device from a wireless master unit, for example a hand held device 80 shown in Figure 3.

Microprocessor 224 can also preferably be used to implement diagnostics functionality. Microprocessor 224 is configured to monitor the voltage and current characteristics of the process control loop 156, improper or problematic variations in current and voltage can be identified using diagnostic techniques and can be transmitted to a remote location, either wirelessly, or using the HART^{®} transmission capabilities provided by circuitry 230, or by setting the current level carried on loop 156 to an alarm value or other predetermined value.

Circuitry 170 is preferably configured to allow operation in hazardous locations and to meet the appropriate approval and specifications, such as intrinsic safety standards. For example, the intrinsic safety protection 190, along with intrinsically safety rated resistor 180 is used on the input to the circuitry 170. Using appropriate components and circuit layout, the addition of a redundant zener diode 192 in parallel with zener 182 provides a level of redundancy and limits the amount of voltage that can enter this circuit in an intrinsic safety protected system. Similarly, the sense resistor 180 can be used to limit the maximum current that can enter the circuit 170 and snub any discharge of stored energy from the circuit through its external terminals. This provides an equivalent capacitance of substantially zero. The loop measurement circuitry is further protected by two intrinsic safety rated high value resistors 194 connected between the two ends of the sense resistor 180 and the filter 220. Other circuit components can be protected from any outside energy sources by the use of potting material or the like which also prevents hazardous gases and vapors from reaching any internal storage elements and nodes in the circuitry 170. For other non-hazardous locations, intrinsic safety components may not be required.

There are a growing number of applications in industrial process plants that utilize the benefits of wireless communications in process transmitters. These transmitters may be monitoring process temperature, pressure, level, or flow. Reasons for providing wireless communications to these devices include the cost savings of installing hundreds or even thousands of feet of wire or to ease the task of "connecting" to and communicating with the process transmitter. For a wired communications system, any host whether it be a process control system, or a portable handheld communicator, must physically connect to wires that are connected to the process transmitter in order to communicate with it. In contrast, with a wireless communications system, the host may wirelessly "connect" to a desired process transmitter from any location in the process plant within communication range. Further, in a wired system, the user must remove the cover from the device in order to gain access to the terminals for connecting a handheld communicator to perform diagnostics or commissioning of the process transmitter. Removing the cover may require the user to take several safety precautions to ensure that the safety features of the process transmitter, or the facility, are not compromised. Further, removing the cover from a process transmitter may require special work procedures, or even process or partial plant shutdowns, if the transmitter is used in a potentially hazardous area in the process plant. A process transmitter with wireless communications capability does not require the removal of the cover, and the related procedures, in order to communicate either locally or from a distant location.

There are a large number of installed process transmitters that have "wired" HART^{®} communications capability. In some instances, it may be desirable to add wireless communications capability to these devices without having the expense of purchasing and installing a new process transmitter with wireless communications built in. Preferably the device interfaces the existing HART^{®} enabled process transmitter to a wireless network. This device can act as a communications translator, communicating via HART^{®} to the existing process transmitters, and communicating over a wireless network to a wireless host or other remote monitoring or diagnostic system. Further, it is preferable that another power source for this communications module is not required. The module should operate from the same power that is already provided to the process transmitter, while not negatively impacting the power available for the process transmitter. This communication device may operate from solar power, but that is not practical in many installations. It may also operate off a battery. However, batteries have special safety drawbacks when used in process plants adding to their expense, and also require periodic replacement, making them undesirable.

Since process transmitters may be scattered across a process plant, it is convenient for the users if they can communicate on a wireless mesh network. A mesh network is one in which each wireless device may serve as a router for the other wireless devices. This ensures that each device in the network has the most reliable communications path back to the host. These communication paths are established when the network is initially established, as well as whenever a new device joins the network. In many instances, it may be desirable that a process control transmitter which is coupled to a two-wire process control loop be also able to communicate information on a wireless network. It may also be desirable that the device function as a router in a "mesh network." Further, in many instances it is preferable that the device operate using power from the process control loop rather than requiring a separate source of power.

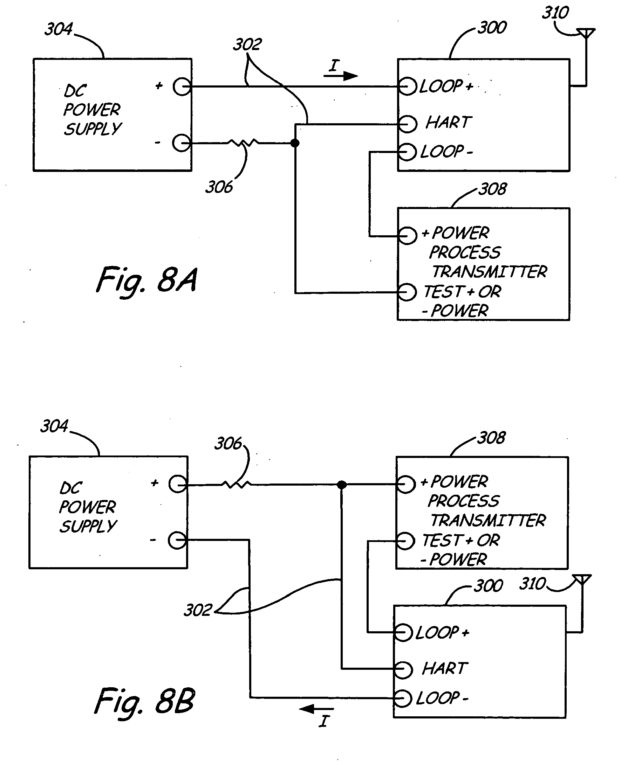

Figure 8A and 8B show two example wiring configurations for a wireless adapter 300 in accordance with one example embodiment. Wireless adapter 300 is shown coupled to a process control loop 302 which is powered by a DC power supply 304. The loop is illustrated as including a load resistance 306 and also couples to a process variable transmitter 308. In Figures 8A and 8B, the wireless adapter 300 includes two loop connections (Loop+ and Loop-) which connect in series with the process control loop 302. One of the loop connections couples to the power supply 304 while the other loop connection couples to a loop connection of the process transmitter 308. The wireless adapter 300 includes a third connection (labeled HART@) which couples to the other loop connection of the process transmitter 308. In the configuration shown in Figure 8A, the Loop- connection of adapter 300 couples to the plus connection of transmitter 308 while the HART^{®} connection of adapter 300 couples to the minus connection (labeled "Test+ or - Power") connection of transmitter 308. The arrangement in Figure 8B is slightly different in which the Loop+ connection of the adapter 300 couples to the minus connection of transmitter 308 while the Loop- connection of adapter 300 couples to the power supply 304 and the HART^{®} connection couples to the plus connection of transmitter 308. The adapter 300 is also illustrated with an antenna 310. In the configurations of Figures 8A and 8B, the adapter 300 is configured as a three terminal device through which all of the loop current I flows. The separate HART^{®} connection is used to provide digital communication on the two wire process control loop 302. Although the Figures are labeled HART^{®}, the adapter is not limited to operating in accordance with the HART@ communication protocol and may use any appropriate protocol including Fieldbus protocols.

The adapter 300 is powered using power received from the process control loop 302. The loop 302 is also used to provide power to the transmitter 308. In one configuration, the adapter 300 regulates its voltage to a small value, for example 1.0 volts, such that it will have a minimal impact on the process control loop 302. The adapter 300 operates using the current available from the loop 302. For example, if the transmitter 308 sets the loop current to a value of 5 mA, the adapter 300 will operate on this 5 mA. If the voltage drop across the adapter is 1 volt, a total of 5 mW will be used by the adapter 300. In the case of a typical process variable transmitter, the loop current is varied between 4 mA and 20 mA based upon a measured process variable. Thus, the minimum power available to the adapter 300 will be about 4 mW and the maximum value available will be about 20 mW. The adapter 300 must utilize this power to perform all desired functions, including, communications on the loop 302 as well as wireless communications. A typical wireless radio may require up to a 3 volt supply and draw between 15 mA and 50 mA during communications (the specifics depend on many parameters related to the wireless network). As this current draw does not occur at all times, it is possible for the adapter to store power until it is needed to support the wireless communication. As discussed above, a super capacitor can be used to store power. These are relatively inexpensive and have relatively long life times. Super capacitors may supply current as high as 1 amp for short periods of time and may therefore be used to power the wireless communication circuitry.

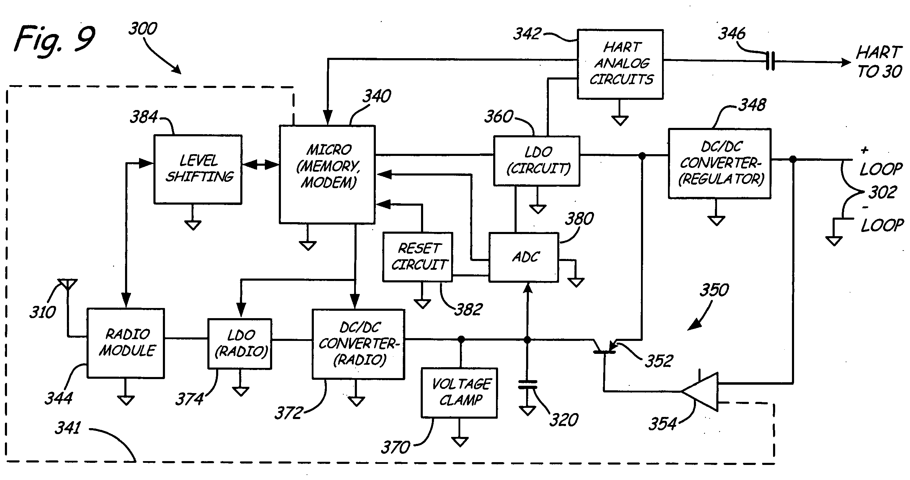

Figure 9 is a simplified block diagram of the adapter 300 which shows various circuitry blocks. A super capacitor 320 is illustrated and the device 300 is configured for HART^{®} communication as well as wireless communication.

As illustrated in Figure 9, adapter 300 includes a microcontroller 340 which also includes a memory and a modem for communication. The memory is used to store programming instructions, configuration data, variables, etc. HART^{®} analog circuitry 342 is configured to couple to the process variable transmitter 308 through a DC blocking capacitor 346. A radio module 344 is provided to enable adapter 300 to communicate using RF communication techniques. A regulator 348 is provided which is configured as a DC to DC converter. A current shunt circuit 350 is connected in parallel with regulator 348 and includes a bypass transistor 352 controlled by a OP amp 354. OP amp 354 operates based upon a difference between a reference voltage (V_{ref}) and the voltage applied to the regulator 348. Regulator 348 provides a 2.3 volt output to a low dropout (LDO) regulator 360. Low dropout (LDO) regulator 360 provides a regulated 2 volt power supply output to the microprocessor 340, HART analog circuits 342, reset circuit 382 and ADC 380.

The current through bypass transistor 352 is used to charge the super capacitor 320. The voltage across the super capacitor 320 is set using a voltage clamp 370. For example, the voltage clamp can be set to 2.2 volts. Another DC to DC converter 372 is configured as a step up converter and provides a regulated voltage output of 3 volts to a low dropout (LDO) regulator 374. The output of low dropout (LDO) regulator 374 is set to 2.8 volts and used to provide regulated power to radio module 344.

The microprocessor 340 is connected to a analog to digital converter 380 which is used to monitor the voltage of super capacitor 320. Microprocessor 340 is also connected to a reset circuit 382. Microprocessor 340 provides data to the radio module 344 through a level shifting circuit 384.

It is preferable that the circuitry be able to support the maximum amount of wireless communication activity while dropping a minimum amount of voltage in the loop 302. Therefore, the adapter 300 is preferably configured to use power from the loop 302 in a very efficient manner. In one specific configuration, this can be achieved by using a low power microcontroller 340, for example, Texas Instruments MSP430F1481 and by using low power analog circuit components. These components can be powered by a low supply voltage to also minimize the total circuit power consumption. Further, the microcontroller 340 can be configured to enter a "sleep" mode if desired when certain functions are not needed, for example communication functions. In the configuration shown in Figure 9, a separate modem is not utilized. Instead, the microcontroller 340 is used to provide modem functionality.

It is also preferable to provide the radio module 344 with a large amount of power. This allows more frequent communication and increased reliability. The additional power can be used to publish information from the transmitter 308, allow the adapter 300 to be used as a router for other process transmitters, for example in a mesh network and allow higher transmit power to be used. This can result in a more reliable mesh network, as the path from another wireless device through the adapter 300 to a host may be more reliable than the path which is directly from the device to the host.

In the embodiment of Figure 9, the radio module 344 is powered by super capacitor 320. Therefore, in order to increase the power which is provided to the radio module 344, it is preferable to increase the power stored by super capacitor 320. In the configuration of Figure 9, this is achieved by arranging the super capacitor 320 as a shunt element for the regulator 348 which regulates the voltage drop across the terminals which couple to loop 302 in conjunction with OP amp 354 and shunt transistor 352. In Figure 9, the voltage across the loop terminals which couple to the process control loop 302 is regulated to one volt. This is achieved by adjusting the current going to the super capacitor using OP amp 354 and shunt transistor 352. In this configuration, regulator 348 operates in series with the loop 302 and is in the feedback loop formed by OP amp 354. In a less efficient configuration, a separate one volt shunt regulator and super capacitor charging circuit may be implemented. However, this requires additional components and additional power to operate. In contrast, in the configuration set forth in Figure 9, any loop current which is not used by the circuitry of adapter 300 is directed into shunt capacitor 320 for increased efficiency. This results in the maximum amount of power being available for radio module 344. The voltage clamp 370 determines the voltage to which capacitor 320 is charged. Once the super capacitor 320 reaches the voltage set by the voltage clamp 370, the excess current flows through clamp 370 rather than into capacitor 320.

DC to DC converter 348 is configured as a low power "step up" switching regulator that operates with an input voltage of 1 volt. Regulator 348 increases the 1 volt input voltage to a sufficiently high voltage to power the remaining circuitry. In the example of Figure 9, this is 2.3 volts. The converter can be a switched capacitor type converter, an inductor based boost converter, a transformer based converter or other appropriate configuration. The LDO regulator 360 regulates the 2.3 volt output from regulator 348 to 2.0 volts and removes any switching noise from the regulator 348. The output from the LDO regulator 360 is used to power the microprocessor 340, HART^{®} analog circuits 342, memory, reset circuitry 382, and analog to digital converter 380.

HART^{®} analog circuit block 342 can comprise, for example, a carrier detect circuit, a receive circuit and a transmit circuit. Preferably, these circuits are configured to have low power requirements while maintaining acceptable communications integrity. The memory in microprocessor 340 can be used to store programming code and temporary variables. Timers which are internal to microprocessor 340 can be used to provide a "software" modem functionality. The memory of the microprocessor 340 may include internal flash memory, RAM as well as EEPROM or other non volatile memory. The microcontroller 340 can be configured to monitor the voltage access super capacitor 320 using analog to digital converter 380 which provides a digital output to microcontroller 340 representative of the capacitive voltage. If desired, the microcontroller 340 can be used to determine whether the capacitor has a sufficient voltage to support radio transmission. Reset circuit 382 can be used to ensure that microcontroller 340 does not operate when the voltage is insufficient. For example, the reset circuit 382 can be configured to reset, or turn on, the microcontroller 340 when the supply voltage from LDO regulator 360 reaches a sufficient voltage level. The circuitry can also be used to reset the microcontroller 340 if a power "glitch" occurs.

Radio module 344 operates on a stable voltage of 2.8 volts provided by LDO regulator 374. As discussed above, if the super capacitor 320 is charged to 2.2 volts, the DC to DC converter regulator 372 steps up the voltage to 3 volts. During use, the voltage on the super capacitor will decrease and the step up converter is needed. The LDO regulator 374 is used to provide a stable 2.8 volts to the radio module 344. Preferably, regulator 372 is configured to operate off a minimum voltage of about 1 volt up to a maximum voltage of about 2.2 volts. In some configurations, microcontroller 340 is configured to turn off circuitry of radio module 344 if the voltage on the super capacitor 320 is less than 1 volt.

Microcontroller 340 can be configured to transmit information wirelessly using the radio module 344 by communicating over digital communication lines between the radio module 344 and the microcontroller 340. As the microcontroller operates from a two volt power supply while the radio operates from a 2.8 power supply, the digital communication lines between the two components must be level shifted using level shifting circuitry 384. For example, this can be performed using very low power level translator circuits such as Texas Instruments SN74LVC2T45DCU.

In one configuration, the microcontroller 340 can be configured to adjust the voltage drop across the loop terminals which couple to loop 302. For example, an optional control line 341 from the microcontroller 340 can be coupled to the inverting input of OP amp 354 of the shunt circuitry 350. In such a configuration, additional power may be made available to the radio by increasing the loop voltage drop under appropriate conditions. Similarly, if the impact on the process control loop of the circuitry of adapter 300 needs to be reduced, the voltage drop can be decreased. However, this will provide less power to the radio module and other circuitry of adapter 300 and may degrade performance.

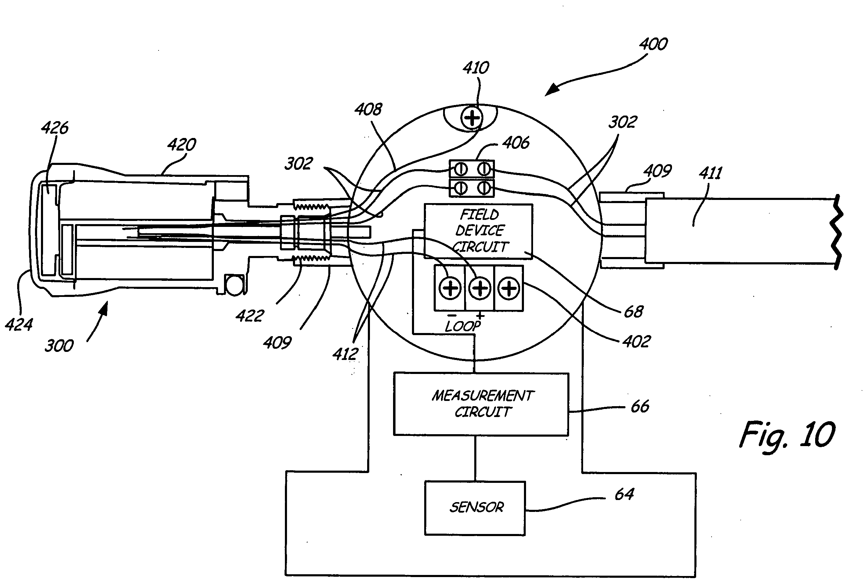

Figure 10 is a cross-sectional view of one embodiment showing a process control transmitter 400 coupled to a wireless adapter 300. Transmitter 400 includes a sensor 64 and measurement circuitry 66 as discussed above. Measurement circuitry 66 couples to field device circuitry 68. Transmitter 400 couples to two wire process control loop 302 through a connection block 406 and the wireless adapter 300. Further, the wireless adapter 300 couples to the housing of transmitter 400. In the example shown in Figure 10, the coupling is through a NPT conduit connection 409. A similar conduit connection 409 is also used to couple to conduit 411 for carrying the two wire process control loop 302 therethrough. The chassis of wireless adapter 300 couples to an electrical ground connection 410 of transmitter 400 through wire 408. The transmitter 400 includes a two wire process control loop connection block 402 which couples to connections 412 from wireless adapter 300. As illustrated in Figure 10, the wireless adapter 300 can be threadably received in conduit connection 409. Housing 420 carries an antenna 426 to support circuitry of the wireless adapter 300. Further, an RF transparent end cap 424 can be sealably coupled to housing 420 and allow transmission of RF signals therethrough. Note that in the arrangement shown in Figure 10, five electrical connections are provided to the RF adapter 300. These include four loop connections as illustrated in either Figures 8A or 8B, along with an electrical ground connection.

As discussed above, in some installations it is important for field equipment such as a wireless adapter, to be intrinsically safe, that is, to be able to be operated in environments in which the atmosphere is flammable or explosive. For example, circuitry in the device can be configured to limit the amount of energy which the device is capable of storing and/or which the device is capable of discharging at any given time. As illustrated above, the wireless adapter is connected in series with a field device such as a process transmitter or control valve and operates using power drawn from the current flowing through the two wire process control loop. A small voltage drop occurs across the wireless adapter. This voltage drop may be as low as 1.0 volts. However, as the current flowing through the two wire process control loop may, in some instances, be as low as 3.5 mA, the instantaneous power available may be as low as 3.5 mW. However, in some configurations, the wireless adapter may require more power. For example, the device may require 60 mW of power (3 volts at 20 mA) in order to transmit a wireless message. Similarly, the power required to receive a wireless transmission may also exceed the instantaneous power which is available from the process control loop. Thus, it is desirable that the wireless adapter be able to store power internally for use when there is insufficient power instantaneously available from the two wire process control loop. Typically, the time required for wireless communication, both transmission and reception, is relatively short while the power available from the process control loop is available from a continual basis. This energy can be stored in a capacitor for subsequent use. A standard capacitor can be used or, in some configurations, a super capacitor having a capacitance greater than 0.22 F. However, a field device which is configured to store energy must contain circuitry to prevent excessive discharge of such energy if the device is desired to operate in an intrinsically safe manner. Although with a super capacitor, the amount of energy coming out of the device must be limited, even if the standard capacitor is employed intrinsic safety requirements still require limitations on the amount of energy coming into the device. The voltage across a given capacitance must be kept below a level that could result in the capacitance creating a spark if the capacitance underwent an instantaneous short circuit. Therefore, limiting the maximum voltage which can be applied to the device allows larger capacitance values to be used while still meeting intrinsic safety limitations.

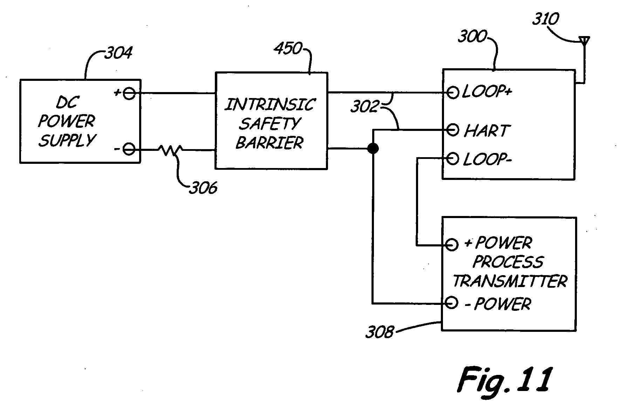

Figure 11 is a simplified diagram similar to Figure 8A showing the wireless adapter 300 coupled to a two wire process control loop 302. In Figure 11, an intrinsic safety barrier 450 is shown as coupled to the two wire process control loop 302. Intrinsic safety barrier 450 limits the voltage and current which can be supplied to any field devices coupled to the loop from power supply 304. Further, in such a configuration, the field device, such as process transmitter 308 can be configured to limit the amount of energy which can be stored within its circuitry. However, as a capacitor, or a super capacitor is capable of storing power, additional circuitry must be provided to ensure that any power stored in adapter 300 cannot be discharged from the device. In another words, in order for a device coupled to process control loop to maintain intrinsic safety, the device must be configured such that any power which it can add back into the loop is limited. This can be particularly problematic if the device stores energy, for example, by using a capacitor.

In one aspect of the invention, circuitry is provided to limit the amount of power which the wireless adapter 300 is capable of discharging back into the process control loop 302 or elsewhere.

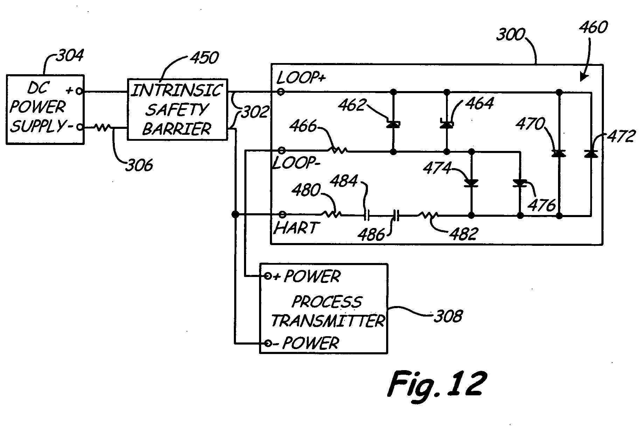

Figure 12 is a simplified block diagram showing wireless adapter 300 including one example configuration of intrinsic safety circuitry 460. In the example of Figure 12, zener diodes 462 and 464 are provided which can comprise, for example, zener diode having a 6.2 volt bias voltage coupled across the loop+ and loop- connections. A 5 ohm resistance 466 is coupled in series with the two wire process control loop 302. Diodes 470 and 472 are coupled across the loop+ connection and the HART^{®} connection to the field device 308. Similarly, diodes 474 and 476 are coupled across the loop- connection and the HART^{®} connection to the field device 308. Resistors 480 and 482, and capacitors 484 and 486 are connected in series with the HART@ connection to the field device 308. In one embodiment, resistor 480 has a value of 49.9 ohms, resistance 482 has a value of 248 ohms, capacitor 484 has a value of 2.2 *µ*F and capacitor 486 has a value of 2.2 *µ*F.

In order to ensure that the wireless adapter meets intrinsic safety requirements, the intrinsic safety circuitry 460 is configured to limit the voltage and current that the circuitry within the adapter 300 is capable of applying to the two wire process control loop 302. This limiting must occur both under normal operating conditions as well as during a fault. Further, the circuitry should be redundant and continue to operate as desired even if some of the circuitry components should fail. In one specific configuration, it is preferable to limit the voltage to less than 1.5 volts and the current to less than 100 mA.

Zener diodes can be used as voltage limiters for the intrinsic safety circuitry 460 and can be configured to conduct current only during a fault condition. In other words, the Zener voltage is selected to be slightly higher than the operating voltage of the circuitry. In this way, the Zener diodes do not waste power during normal circuitry operation. Thus, in order to limit the voltage into or out of the wireless adapter 300 to be less than 1.5 volts, the operating voltage of the wireless adapter electronics must be less than 1.5 volts.

In operation Zener diodes 462 and 464 operate to limit the voltage which can applied between the loop + and loop - terminals. Similarly, diodes 470 and 472 operate to limit the voltage which can be introduced into the circuitry by the loop + and HART^{®} terminals. Diodes 474 and 476 limit the voltage which can be introduced through the loop - in HART^{®} terminals. If the voltage applied across these terminals exceeds the thresholds of the diodes, the diodes will conduct and thereby limit the voltage value. However, during normal operating conditions, the diodes are not conducting and therefore will not have any affect on operation of the circuitry. The resistance which is added in series with the capacitance acts to reduce the amount of charge which can be instantaneously removed from the capacitance, and therefore reduces the chance that a capacitance may cause a spark. For a particular voltage level, additional capacitance may be used in circuitry if there is additional resistance in series with the capacitance. The larger the resistance, the larger that the capacitance may be. The resistance that is connected to the HART^{®} terminal also limits the amount of current which can be provided from that terminal.

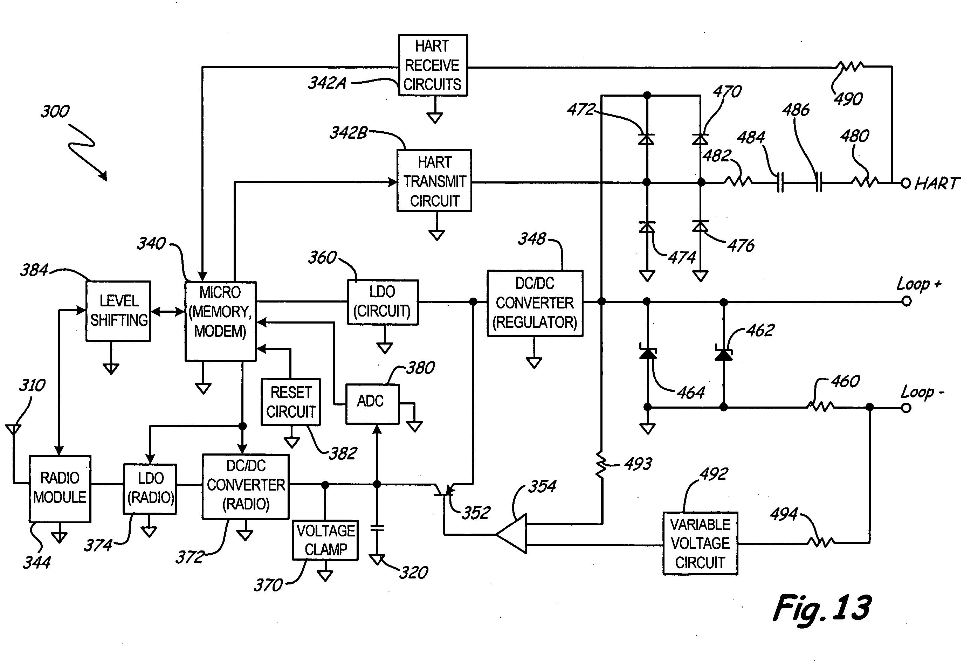

Figure 13 is a more detailed block diagram similar to Figure 9. Some of the elements have retained their numbering. In Figure 13, the HART^{®} analog circuit 342 is illustrated as two separate components, receive circuit 342A and transmit circuit 342B. The HART@ receive circuit 342A couples to the HART^{®} connection through resistor 490 which can comprise, for example, a 10K ohm resistance. Further, the input to the differential amplifier 354 is provided by variable voltage circuitry 492 and also couples to the Loop + terminal through resistor 493. The variable voltage circuit 492 couples to the Loop - connection through resister 494 which can comprise, for example, 12.1K ohms.

In the circuitry discussed above, diodes, such as Zener diodes are used to provide intrinsically safe circuitry. However, the Zener diodes are generally rated at 3.3 volts or higher, which exceeds the desired limits for intrinsic safety. One such technique which can be used to limit the voltages to less than 3.3 volts is to use active shunt regulators instead of Zener diodes. These regulators can be set to limit the voltage to 1.24 volts without requiring any external resisters, or to higher voltages through the use of resisters in the circuitry. However, one drawback to using active shunt regulators is that they are typically only rated to handle relatively small power levels, for example 0.20 to 0.25 watts. Therefore, the power that they dissipate must be limited through the use of a fuse or the like.

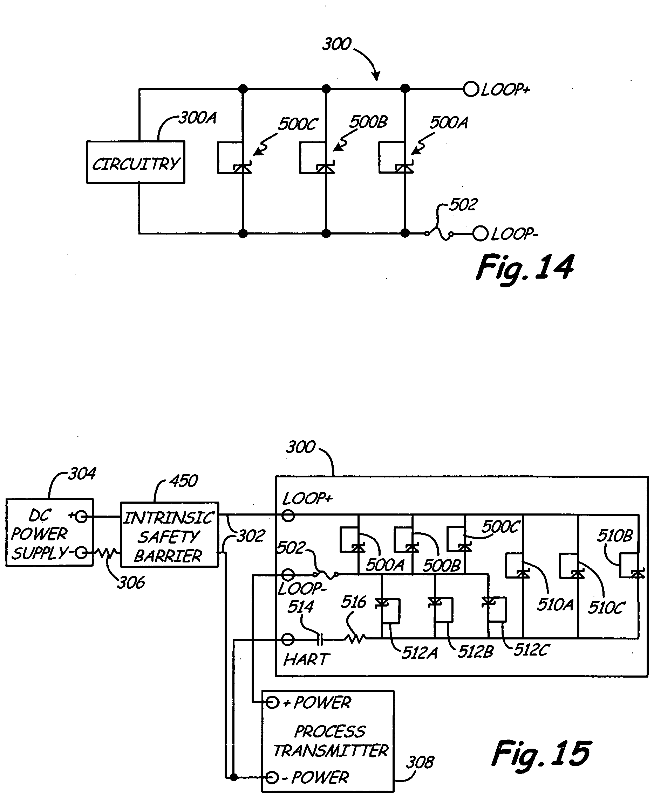

Figure 14 is a simplified schematic diagram showing wireless adapter 300, and wireless adapter circuitry shown generally at 300A, which includes three active shunt regulators 500A, 500B and 500C connected across the loop+ and loop- terminals. A fuse 502 is connected in series with the loop connection. The shunt regulators may comprise, for example, TLVH431 regulators available from Texas Instruments. In accordance with intrinsic safety principles, as the shunt regulators are active circuits, three shunt regulators must be provided for redundancy. The regulators are arranged so that they limit both the voltage that can be applied to the two wire process control loop 302 as well as the voltage which is applied to circuitry 300A.

However, one additional complicating factor in providing intrinsic safety by limiting both voltage and current that the wireless adapter 300 can place on the control loop is that the adapter 300 circuitry includes a third connection. This is the communication connection identified as the HART@ connection in the description set forth herein. Intrinsic safety requirements require that the voltage and current which the adapter 300 is capable of outputting at any time be limited for any combination of its three terminals. Therefore, active shunt regulators can also be used with the HART^{®} connection as illustrated in Figure 15. As illustrated in Figure 15, two additional sets of active shunt regulators are required. Shunt regulators 510A, 510B and 510C are connected between the loop+ terminal and the HART^{®} terminal. Similarly, active shunt regulators 512A, 512B and 512C are connected between the loopterminal and the HART^{®} terminal. A capacitor 514 and resistance 516 are provided as discussed above.

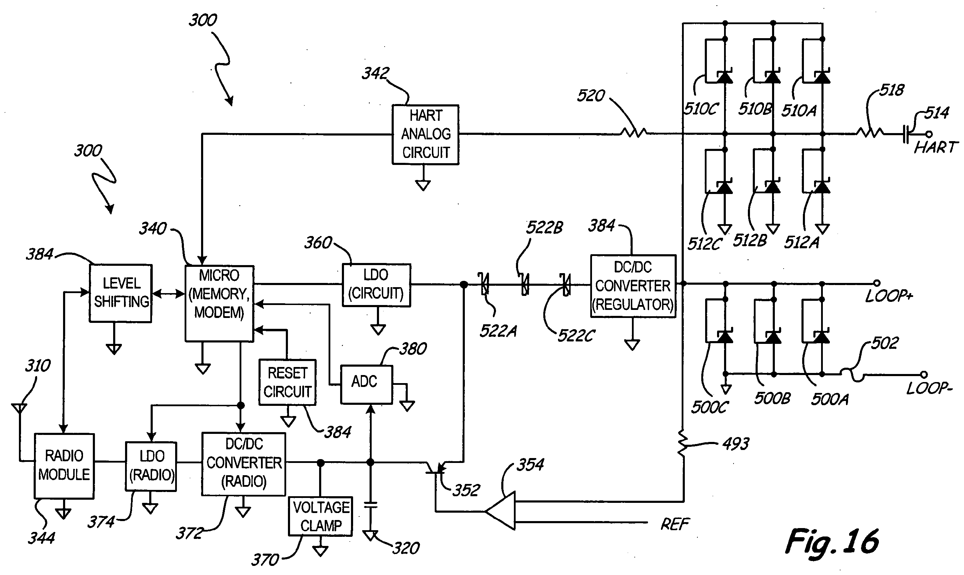

Another method that may be used to limit the current that a capacitor can place on to the process control loop is to insert an electrical resistance at any path from the capacitor to the loop terminals. However, this requires a resistance between the step up DC to DC converter 384 and the capacitor to limit the current to 100 mA which will result in a very large power loss. Less power is lost if three voltage drop Schottky diodes are placed in series between the DC to DC converter in the capacitor. An example of such circuitry is illustrated at Figure 16. In this configuration, the connection to the HART^{®} terminal can be limited by using a sufficiently large resistance 518 and 520. Three Schottky diodes 522A, 522B and 522C are used to couple the DC to DC converter 384 to the circuitry of the wireless adapter 300. An example Schottky diode is an RV161M available from Rohm of Piano, Texas. Other potential paths from the capacitor 320 to the terminals include high resistive elements such as the connection through amplifier 354.

In the above discussion, capacitor 320 comprises a "regular" capacitor having a capacitance of, for example, 10,000*µ*F. However, in some configurations, it may be desirable to store additional energy. In such a configuration, a "super capacitor" can be used which may have a capacitance of 0.1 Farads or more. If a super capacitor is used for capacitance 320, alternative configurations must be used to provide intrinsic safety. This is because the maximum discharge from the circuitry must be limited. In general, the lower value to which the voltage and current are limited, the less energy the circuitry will be capable of providing back into the process control loop. For example, it is desirable to limit the voltage to 1.5 volts or less and the current to 100mA or less.

The above configuration provides an adapter which enables wireless communication with a process variable transmitter. The circuitry can be configured to operate from power which is already available to the process variable transmitter. Increased efficiency can be obtained by placing the energy storage element as a shunt element in a loop shunt regulator. A "step up" regulator can be provided which is part of the feedback circuit for the shunt regulator control. This configuration increases efficiency while reducing the number of components required.

The term "field device" as used herein can be any device which is used in a process controller monitoring system and does not necessarily require placement in the "field." The device can be located anywhere in the process control system including in a control room or control circuitry. The terminals used to connect to the process control loop refer to any electrical connection and may not comprise physical or discrete terminals. Any appropriate radio frequency communication circuitry can be used as desired as can any appropriate communication protocol, frequency or communication technique. The power supply circuitry is configured as desired and is not limited to the configurations set forth herein. In some embodiments, the field device includes an address which can be included in any RF transmissions such that the device can be identified. Similarly, such an address can be used to determine if a received signal is intended for that particular device. However, in other embodiments, no address is utilized and data is simply transmitted from the wireless communication circuitry without any addressing information. In such a configuration, if receipt of data is desired, any received data may not include addressing information. In some embodiments, this may be acceptable. In others, other addressing techniques or identification techniques can be used such as assigning a particular frequency or communication protocol to a particular device, assigning a particular time slot or period to a particular device or other techniques. Any appropriate communication protocol and/or networking technique can be employed including token-based techniques in which a token is handed off between devices to thereby allow transmission or reception for the particular device.

Although the present invention has been described with reference to preferred embodiments, workers skilled in the art will recognize that changes may be made in form and detail without departing from the scope of the invention. As used herein, Radio Frequency (RF) can comprise electromagnetic transmissions of any frequency and is not limited to a particular group of frequencies, range of frequencies or any other limitation. Any communication protocol can be used, as desired, including IEEE 802.11b, 802.15.4, or other protocols, including proprietary protocols as well as standardized protocols such as the wireless HART@ communication protocol. In the discussion above, the wireless adapter provides a digital signal communication connection for coupling to the two wire process control loop and, in some embodiments, communicating in accordance with the HART^{®} communication protocol. This connection is illustrated in Figures 8A and 8B as being a parallel connection with the process variable transmitter and which does not carry substantial loop current. The power connection is illustrated as being in series with the process control loop. As used herein, bypass circuitry includes the bypass configurations shown in Figures 4 and 5, the shunt configurations shown in Figures 7 and 9, or other circuitry. The adapter can be configured to mount externally to a process control transmitter, for example, through a threaded coupling to NPT fittings in the transmitter housing. In the above discussion, when a capacitor which is not a super capacitor is employed, for example on the order of 10,000*µ*F is used to store energy, the intrinsic safety circuitry of the present invention operates to limit the maximum available energy which is entering the circuitry of the adapter. This is because in accordance with intrinsic safety standard, the voltage across a given capacitance must be kept below a level that could result in the capacitance creating a spark if an instantaneous short circuit occurred. Thus, in the above discussion, by limiting the maximum circuit voltage which can be received by circuitry in the adapter, the size of the capacitance can be increased. However, for extremely large capacitance values, i.e. "super capacitors", the capacitor must be treated as an energy storage device. In such configurations, the intrinsic safety circuitry of the present invention operates to limit the maximum amount of energy which can come out of the adapter circuitry. In the above discussion, the maximum current and voltage which can be produced by the adapter is limited to 1.24 volts and 100 mA. Thus, the intrinsic safety circuitry of the present invention operates in two different manners depending upon the size of the capacitance employed.

## Claims

1. An adapter (300) for coupling to a process control transmitter (400) of the type used to monitor a process variable in an industrial process, the adapter (300) comprising:
a first adapter connection (Loop+) coupled to a first wire of a two wire process control loop (302);
a second adapter connection (Loop-) coupled to a first transmitter connection of the process control transmitter (400);
a third adapter connection (HART@) coupled to a second transmitter connection of the process control transmitter (400) and a second wire of the two wire process control loop (302), wherein the third adapter connection is configured to provide digital communication on the two wire process control loop (302);
wireless communication circuitry configured to provide wireless communication for the process control transmitter (400), wherein the first and second adapter connections (Loop+, Loop-) are configured to power the wireless communication circuitry;
a capacitor (320) configured to store energy for use in operating the wireless communication circuitry;
a regulator (348) configured to perform a DC-DC conversion;
a shunt circuit (350) connected in parallel to the regulator (348) and including a bypass transistor (352) controlled by an operational amplifier (354), wherein a current through the bypass transistor (352) is used to charge the capacitor (320), and wherein the regulator (348) operates in series with the control loop (302) and is in a feedback loop formed by the operational amplifier (354), and
intrinsic safety circuitry (460) coupled to at least one of the first, second and third adapter connections (Loop+, Loop-, HART^{®}) configured to limit energy transfer to a value which is less than a predetermined value, wherein the intrinsic safety circuitry (460) is configured to limit the energy transfer which the wireless adapter (300) discharges back into the two wire loop (302), and the two wire loop (302) is further configured to carry information communicated from the third adapter connection,
wherein the intrinsic safety circuitry (460) is coupled in series between the capacitor (114) and the at least one of the first, second and third adapter connections (Loop+, Loop-, HART^{®}).

2. The adapter of claim 1 wherein the intrinsic safety circuitry (460) comprises a diode, especially a zener diode.

3. The adapter of claim 2 wherein the diode is connected between the first and second adapter connections (Loop+, Loop-) or wherein the diode is connected between the second and third adapter connections (Loop-, HART@) or wherein the diode is connected between the first and third adapter connections (Loop+, HART@).

4. The adapter of claim 2 wherein the intrinsic safety circuitry (460) is coupled between the first, second and third adapter connections (Loop+, Loop-, HART^{®}).

5. The adapter of claim 1 wherein the capacitor (114) is a supercapacitor, and wherein the intrinsic safety circuitry (460) is coupled in series between the capacitor (114) and the at least one of the first, second and third adapter connections (Loop+, Loop-, HART^{®}).

6. The adapter of claim 1 wherein the intrinsic safety circuitry (460) comprises active circuitry.

7. The adapter of claim 6 wherein the active circuitry providing triple redundancy of components or wherein the active circuitry comprises an active shunt.

8. The adapter of claim 1 including a fuse coupled in series with at least one of the first, second and third adapter connections (Loop+, Loop-, HART^{®}).

9. The adapter of claim 7 wherein the intrinsic safety circuitry (460) comprises a diode or a resistance.

10. The adapter of claim 1 wherein the intrinsic safety circuitry (460) limiting storage of electrical energy stored in the adapter (300) to a value which is less than the intrinsic safety value or wherein the wireless communication circuitry is powered with electrical power received from the two wire process control loop (302) or including communication circuitry communicating with the process control transmitter (400).

11. A method of coupling a wireless adapter (300) to a process control transmitter (400) of the type used to monitor a process variable in an industrial process, the method comprising:
coupling a first adapter connection (Loop+) to a first wire of a two wire process control loop (302);
coupling a second adapter connection (Loop-) to a first transmitter connection of the process control transmitter (400);
coupling a third adapter connection (HART@) to a second transmitter connection of the process control transmitter (400) and to a second wire of the two wire process control loop (302), wherein the third adapter connection (HART@) is capable of providing digital communication on the two wire process control loop (302);
powering wireless communication circuitry with power received from the two wire process control loop (302) through the first and second adapter connections (Loop+, Loop-); and
limiting energy transfer which the wireless adapter (300) discharges back into the two wire loop (302) through at least one of the first, second and third adapter connections to a value which is less than a predetermined value by intrinsic safety circuitry (460) coupled in series between the capacitor (114) and the at least one of the first, second and third adapter connections, wherein the two wire loop is further configured to carry information communicated from the third adapter connection,
wherein the wireless communication circuitry is operated by energy stored in a capacitor;
a DC-DC conversion is performed by a regulator (348) including a shunt circuit (350) connected in parallel to the regulator (348) and including a bypass transistor (352) controlled by an operational amplifier (354),
wherein a current through the bypass transistor (352) is used to charge the capacitor (320), and
wherein the regulator (348) operates in series with the control loop (302) and is in a feedback loop formed by the operational amplifier (354).

12. The method of claim 11 wherein limiting energy transfer comprising limiting energy going into circuitry of the adapter (300) or coming out of circuitry in the adapter (300).

13. The method of claim 11 including storing energy in a super capacitor.

14. The method of claim 12 including limiting storage of electrical energy in the adapter (300) to a value which is less than the value of the intrinsic safety value.

15. The method of claim 11 including communicating with the process control transmitter (400) using the third connection.

## Patentansprüche

1. Adapter (300) zum Koppeln mit einem Prozesssteuerungssender (400) des Typs, der zum Überwachen einer Prozessvariable in einem industriellen Prozess verwendet wird, wobei der Adapter (300) umfasst:
einen ersten Adapteranschluss (Loop+), der mit einem ersten Draht einer Zweidraht-Prozesssteuerschleife (302) gekoppelt ist;
einen zweiten Adapteranschluss (Loop-), der mit einem ersten Senderanschluss des Prozesssteuersenders (400) gekoppelt ist;
einen dritten Adapteranschluss (HART^{®}), der mit einem zweiten Senderanschluss des Prozesssteuersenders (400) und einem zweiten Draht der Zweidraht-Prozesssteuerschleife (302) gekoppelt ist, wobei der dritte Adapteranschluss dafür eingerichet ist, eine digitale Kommunikation in der Zweidraht-Prozesssteuerschleife (302) zu ermöglichen;
eine Drahtloskommunikationsschaltung, die dafür eingerichet ist, eine Drahtloskommunikation für den Prozesssteuersender (400) zu ermöglichen, wobei der erste und der zweite Adapteranschluss (Loop+, Loop-) dafür eingerichet sind, die Drahtloskommunikationsschaltung mit Strom zu versorgen;
einen Kondensator (320), der dafür eingerichet ist, Energie zur Verwendung beim Betreiben der Drahtloskommunikationsschaltung zu speichern;
einen Regler (348), der dafür eingerichet ist, eine Gleichstrom-Gleichstrom-Wandlung durchzuführen;
einen Nebenschlusskreis (350), der zu dem Regler (348) parallel geschaltet ist und einen Umgehungstransistor (352) umfasst, der durch einen Operationsverstärker (354) gesteuert wird, wobei ein Strom durch den Umgehungstransistor (352) verwendet wird, um den Kondensator (320) zu laden, und wobei der Regler (348) in Reihe mit der Steuerschleife (302) arbeitet und sich in einer Rückkopplungsschleife befindet, die durch den Operationsverstärker (354) gebildet wird, und
eine Eigensicherheitsschaltung (460), die mit mindestens einem des ersten, des zweiten und des dritten Adapteranschlusses (Loop+, Loop-, HART^{®}) gekoppelt ist und dafür eingerichet ist, die Energieübertragung auf einen Wert zu begrenzen, der kleiner als ein zuvor festgelegter Wert ist, wobei die Eigensicherheitsschaltung (460) dafür eingerichet ist, die Energieübertragung zu begrenzen, die der Drahtlosadapter (300) zurück in die Zweidrahtschleife (302) entlädt, und die Zweidrahtschleife (302) des Weiteren dafür eingerichet ist, Informationen zu transportieren, die von dem dritten Adapteranschluss übermittelt werden,
wobei die Eigensicherheitsschaltung (460) zwischen dem Kondensator (114) und dem mindestens einen des ersten, des zweiten und des dritten Adapteranschlusses (Loop+, Loop-, HART^{®}) in Reihe geschaltet ist.

2. Adapter nach Anspruch 1, wobei die Eigensicherheitsschaltung (460) eine Diode, insbesondere eine Zenerdiode, umfasst.

3. Adapter nach Anspruch 2, wobei die Diode zwischen dem ersten und dem zweiten Adapteranschluss (Loop+, Loop-) verbunden ist oder wobei die Diode zwischen dem zweiten und dem dritten Adapteranschluss (Loop-, HART^{®}) verbunden ist oder wobei die Diode zwischen dem ersten und dem dritten Adapteranschluss (Loop+, HART^{®}) verbunden ist.

4. Adapter nach Anspruch 2, wobei die Eigensicherheitsschaltung (460) zwischen dem ersten, dem zweiten und dem dritten Adapteranschluss (Loop+, Loop-, HART^{®}) gekoppelt ist.

5. Adapter nach Anspruch 1, wobei der Kondensator (114) ein Superkondensator ist und
wobei die Eigensicherheitsschaltung (460) zwischen dem Kondensator (114) und dem mindestens einen des ersten, des zweiten und des dritten Adapteranschlusses (Loop+, Loop-, HART^{®}) in Reihe geschaltet ist.

6. Adapter nach Anspruch 1, wobei die Eigensicherheitsschaltung (460) eine aktive Schaltung umfasst.

7. Adapter nach Anspruch 6, wobei die aktive Schaltung dreifache Redundanz von Komponenten bereitstellt oder wobei die aktive Schaltung einen aktiven Nebenschluss umfasst.

8. Adapter nach Anspruch 1, umfassend eine Sicherung, die mit mindestens einem des ersten, des zweiten und des dritten Adapteranschlusses (Loop+, Loop-, HART^{®}) in Reihe geschaltet ist.

9. Adapter nach Anspruch 7, wobei die Eigensicherheitsschaltung (460) eine Diode oder einen Widerstand umfasst.

10. Adapter nach Anspruch 1, wobei die Eigensicherheitsschaltung (460) die Speicherung von in dem Adapter (300) gespeicherter elektrischer Energie auf einen Wert begrenzt, der kleiner als der Eigensicherheitswert ist, oder wobei die Drahtloskommunikationsschaltung mit elektrischer Energie versorgt wird, die von der Zweidraht-Prozesssteuerschleife (302) empfangen wird, oder eine Kommunikationsschaltung umfasst, die mit dem Prozesssteuersender (400) kommuniziert.

11. Verfahren zum Koppeln eines Drahtlosadapters (300) mit einem Prozesssteuersender (400) des Typs, der zum Überwachen einer Prozessvariable in einem industriellen Prozess verwendet wird, wobei das Verfahren umfasst:
Koppeln eines ersten Adapteranschlusses (Loop+) mit einem ersten Draht einer Zweidraht-Prozesssteuerschleife (302);
Koppeln eines zweiten Adapteranschlusses (Loop-) mit einem ersten Senderanschluss des Prozesssteuersenders (400);
Koppeln eines dritten Adapteranschlusses (HART^{®}) mit einem zweiten Senderanschluss des Prozesssteuersenders (400) und mit einem zweiten Draht der Zweidraht-Prozesssteuerschleife (302), wobei der dritte Adapteranschluss (HART^{®}) in der Lage ist, eine digitale Kommunikation in der Zweidraht-Prozesssteuerschleife (302) zu ermöglichen;
Versorgen einer Drahtloskommunikationsschaltung mit Strom, der von der Zweidraht-Prozesssteuerschleife (302) über den ersten und den zweiten Adapteranschluss (Loop+, Loop-) empfangen wird; und
Begrenzen der Energieübertragung, die der Drahtlosadapter (300) über mindestens einen des ersten, des zweiten und des dritten Adapteranschlusses zurück in die Zweidrahtschleife (302) entlädt, auf einen Wert, der kleiner als ein zuvor festgelegter Wert ist, durch eine Eigensicherheitsschaltung (460), die zwischen dem Kondensator (114) und dem mindestens einen des ersten, des zweiten und des dritten Adapteranschlusses in Reihe geschaltet ist, wobei
die Zweidrahtschleife des Weiteren dafür eingerichet ist, Informationen zu transportieren, die von dem dritten Adapteranschluss übermittelt werden,
wobei die Drahtloskommunikationsschaltung durch in einem Kondensator gespeicherte Energie betrieben wird;
eine Gleichstrom-Gleichstrom-Wandlung durch einen Regler (348) durchgeführt wird, der einen Nebenschlusskreis (350) umfasst, der zu dem Regler (348) parallel geschaltet ist und einen Umgehungstransistor (352) umfasst, der durch einen Operationsverstärker (354) gesteuert wird, wobei ein Strom durch den Umgehungstransistor (352) zum Laden des Kondensators (320) verwendet wird, und
wobei der Regler (348) in Reihe mit der Steuerschleife (302) arbeitet und sich in einer durch den Operationsverstärker (354) gebildeten Rückkopplungsschleife befindet.

12. Verfahren nach Anspruch 11, wobei das Begrenzen der Energieübertragung das Begrenzen der Energie umfasst, die in die Schaltung des Adapters (300) hineinfließt oder aus der Schaltung in dem Adapter (300) herausfließt.

13. Verfahren nach Anspruch 11, umfassend das Speichern von Energie in einem Superkondensator.

14. Verfahren nach Anspruch 12, umfassend, das Speichern von elektrischer Energie in dem Adapter (300) auf einen Wert zu begrenzen, der kleiner als der Wert des Eigensicherheitswertes ist.

15. Verfahren nach Anspruch 11, umfassend das Kommunizieren mit dem Prozesssteuersender (400) unter Verwendung des dritten Anschlusses.

## Revendications

1. Adaptateur (300) destiné à être couplé à un transmetteur de commande de processus (400) du type utilisé pour surveiller une variable de processus dans un processus industriel, l'adaptateur (300) comprenant :
une première connexion d'adaptateur (Loop+) couplée à un premier fil d'une boucle de commande de processus à deux fils (302) ;
une deuxième connexion d'adaptateur (Loop-) couplée à une première connexion de transmetteur du transmetteur de commande de processus (400) ;
une troisième connexion d'adaptateur (HART@) couplée à une seconde connexion de transmetteur du transmetteur de commande de processus (400) et à un second fil de la boucle de commande de processus à deux fils (302), dans lequel la troisième connexion d'adaptateur est configurée pour assurer la communication numérique sur la boucle de commande de processus à deux fils (302) ;
des circuits de communication sans fil configurés pour assurer la communication sans fil au transmetteur de commande de processus (400), dans lequel les première et deuxième connexions d'adaptateur (Loop+, Loop-) sont configurées pour alimenter les circuits de communication sans fil ;
un condensateur (320) configuré pour stocker de l'énergie à utiliser pour faire fonctionner les circuits de communication sans fil ;
un régulateur (348) configuré pour effectuer une conversion continu-continu ;
un circuit en dérivation (350) connecté en parallèle avec le régulateur (348) et comportant un transistor de dérivation (352) commandé par un amplificateur opérationnel (354), dans lequel un courant traversant le transistor de dérivation (352) est utilisé pour charger le condensateur (320), et dans lequel le régulateur (348) fonctionne en série avec la boucle de commande (302) et se trouve dans une boucle de rétroaction formée par l'amplificateur opérationnel (354), et
des circuits de sécurité intrinsèque (460) couplés à au moins l'une des première, deuxième et troisième connexions d'adaptateur (Loop+, Loop-, HART^{®}), configurés pour limiter le transfert d'énergie à une valeur qui est inférieure à une valeur prédéterminée, dans lequel les circuits de sécurité intrinsèque (460) sont configurés pour limiter le transfert d'énergie que l'adaptateur sans fil (300) renvoie dans la boucle à deux fils (302), et la boucle à deux fils (302) est configurée en outre pour transporter des informations communiquées à partir de la troisième connexion d'adaptateur, dans lequel les circuits de sécurité intrinsèque (460) sont couplés en série entre le condensateur (114) et l'au moins une des première, deuxième et troisième connexions d'adaptateur (Loop+, Loop-, HART@).

2. Adaptateur selon la revendication 1, dans lequel les circuits de sécurité intrinsèque (460) comprennent une diode, en particulier une diode Zener.

3. Adaptateur selon la revendication 2, dans lequel la diode est connectée entre la première et la deuxième connexion d'adaptateur (Loop+, Loop-) ou dans lequel la diode est connectée entre la deuxième et la troisième connexion d'adaptateur (Loop-, HART^{®}) ou dans lequel la diode est connectée entre la première et la troisième connexion d'adaptateur (Loop+, HART@).

4. Adaptateur selon la revendication 2, dans lequel les circuits de sécurité intrinsèque (460) sont couplés entre les première, deuxième et troisième connexions d'adaptateur (Loop+, Loop-, HART^{®}).

5. Adaptateur selon la revendication 1, dans lequel le condensateur (114) est un supercondensateur, et dans lequel les circuits de sécurité intrinsèque (460) sont couplés en série entre le condensateur (114) et l'au moins une des première, deuxième et troisième connexions d'adaptateur (Loop+, Loop-, HART^{®}).

6. Adaptateur selon la revendication 1, dans lequel les circuits de sécurité intrinsèque (460) comprennent des circuits actifs.

7. Appareil adaptateur selon la revendication 6, dans lequel les circuits actifs assurent une triple redondance de composants ou dans lequel les circuits actifs comprennent un shunt actif.

8. Appareil adaptateur selon la revendication 1, comprenant un fusible couplé en série avec au moins l'une des première, deuxième et troisième connexions d'adaptateur (Loop+, Loop-, HART@).

9. Adaptateur selon la revendication 7, dans lequel les circuits de sécurité intrinsèque (460) comprennent une diode ou une résistance.

10. Adaptateur selon la revendication 1, dans lequel les circuits de sécurité intrinsèque (460) limitent le stockage d'énergie électrique stockée dans l'adaptateur (300) à une valeur qui est inférieure à la valeur de sécurité intrinsèque ou dans lequel les circuits de communication sans fil sont alimentés en énergie électrique reçue de la boucle de commande de processus à deux fils (302) ou comprennent des circuits de communication communiquant avec le transmetteur de commande de processus (400).

11. Procédé de couplage d'un adaptateur sans fil (300) à un transmetteur de commande de processus (400) du type utilisé pour surveiller une variable de processus dans un processus industriel, le procédé comprenant les étapes suivantes :
coupler une première connexion d'adaptateur (Loop+) à un premier fil d'une boucle de commande de processus à deux fils (302) ;
coupler une deuxième connexion d'adaptateur (Loop-) à une première connexion de transmetteur du transmetteur de commande de processus (400) ;
coupler une troisième connexion d'adaptateur (HART@) à une seconde connexion de transmetteur du transmetteur de commande de processus (400) et à un second fil de la boucle de commande de processus à deux fils (302), dans lequel la troisième connexion d'adaptateur (HART@) est apte à assurer la communication numérique sur la boucle de commande de processus à deux fils (302) ;
alimenter les circuits de communication sans fil avec l'énergie reçue de la boucle de commande de processus à deux fils (302) par l'intermédiaire des première et deuxième connexions d'adaptateur (Loop+, Loop-) ; et
limiter le transfert d'énergie que l'adaptateur sans fil (300) renvoie dans la boucle à deux fils (302) par l'intermédiaire de l'une des première, deuxième et troisième connexions d'adaptateur à une valeur qui est inférieure à une valeur prédéterminée, au moyen de circuits de sécurité intrinsèque (460) couplés en série entre le condensateur (114) et l'au moins une des première, deuxième et troisième connexions d'adaptateur,
dans lequel la boucle à deux fils est configurée en outre pour transporter des informations communiquées à partir de la troisième connexion d'adaptateur,
dans lequel les circuits de communication sans fil fonctionnent au moyen de l'énergie stockée dans un condensateur ;
une conversion continu-continu est effectuée par un régulateur (348) comportant un circuit en dérivation (350) connecté en parallèle avec le régulateur (348) et comportant un transistor de dérivation (352) commandé par un amplificateur opérationnel (354),
dans lequel un courant traversant le transistor de dérivation (352) est utilisé pour charger le condensateur (320), et
dans lequel le régulateur (348) fonctionne en série avec la boucle de commande (302) et se trouve dans une boucle de rétroaction formée par l'amplificateur opérationnel (354).

12. Procédé selon la revendication 11, dans lequel la limitation du transfert d'énergie comprend la limitation de l'énergie entrant dans les circuits de l'adaptateur (300) ou sortant des circuits de l'adaptateur (300).

13. Procédé selon la revendication 11, comprenant le stockage d'énergie dans un supercondensateur.

14. Procédé selon la revendication 12, comprenant la limitation du stockage d'énergie électrique dans l'adaptateur (300) à une valeur qui est inférieure à la valeur de la sécurité intrinsèque.

15. Procédé selon la revendication 11, comprenant la communication avec le transmetteur de commande de processus (400) à l'aide de la troisième connexion.
